# EUROPEAN PATENT APPLICATION

(11) **EP 3 855 198 A1**
(43) Date of publication of application: **28.07.2021**
(21) Application number: 20153574.7
(22) Date of filing: 24.01.2020
(51) Int. Cl.: G01R 33/36, G01R 33/422, G01R 33/34, G01R 33/341, G01R 33/3415, G01R 33/58

(54) **A COIL ASSEMBLY FOR MR IMAGING APPLICATIONS**

(71) Applicant: Skope Magnetic Resonance Technologies AG, 8037 Zürich (CH)
(72) Inventor: The designation of the inventor has not yet been filed
(74) Representative: Schmauder & Partner AG Patent- & Markenanwälte VSP

(57) **Abstract**

A coil assembly for MR imaging applications comprises
- an electrically conducting RF transmitter coil arrangement (2) for generating an excitation field at an MR operating frequency, the transmitter coil arrangement forming a tubular structure disposed around an imaging volume (4) and having a longitudinal axis (A);
- an external RF shield (6) surrounding the transmitter coil arrangement;
- at least one electrically conducting RF receiver coil (8; 8a, 8b) disposed within the imaging volume for receiving MR signal from a subject or object disposed therein, the receiver coil being electrically connected, at a connection point (10; 10a, 10b) thereof, to a respective RF receive line (12; 12a, 12b) connectable to a receiver device (14) located outside of the external RF shield.

In order to improve the performance of the coil assembly, the respective RF receive line of each receiver coil is oriented substantially perpendicular to the longitudinal axis (A) in a receiver-proximal segment (16; 16a, 16b) between the connection point (10; 10a, 10b) and a neighboring face portion (18; 18a, 18b) of the external RF shield through which the receive line (12; 12a, 12b) is conducted.

## Description

### Field of the Invention

The present invention generally relates to a coil assembly for magnetic resonance (MR) imaging applications.

### Description of the prior art

In MR imaging and spectroscopy, magnetic fields are used to manipulate nuclear magnetic resonance signals. Typically, time-varying magnetic gradient fields in multiple directions are superimposed to a constant, homogeneous main magnetic field to create spatial modulations of the local magnetic field across the object under examination. The homogeneous field is usually generated by a superconductive electromagnet. The gradient fields are usually generated by applying specifically shaped current waveforms to a plurality of gradient coils. MR excitation is achieved by application of a radio frequency (RF) field at the so-called Larmor frequency, according to a pre-defined pulse sequence, followed by RF signal detection. The acquired RF signal is then converted to image or spectral information by means of known methods.

According to one mode of operation, distinct sets of RF coils are used for MR excitation and for MR detection. In particular, one may use comparatively large RF coils, also called body coils or volume coils, which substantially surround the entire field of interest. One known type of volume coils is the so-called "birdcage coil", which is advantageously used for MR excitation. MR signal acquisition is advantageously done with so-called surface receiver coils. Surface receiver coils have an intrinsically higher and more localized sensitivity, thus leading to an enhanced signal-to-noise ratio (SNR) which can be used to improve image quality, reduce scan times or to implement parallel imaging techniques such as sensitivity encoding (SENSE).

Optimal SNR performance is achieved by covering the imaging region on the subject or object as completely as possible and with a large number of receiver coils. In practice, this requires having arrays of mechanically individual coils of a number of different sizes and shapes to cover as many imaging situations and patient sizes as possible. Positioning and holding such individual receiver coils is challenging and poses several practical problems.

In particular, routing the cabling in the field produced by the transmitter used for MR excitation inflicts technical problems which are critical for safe and efficient operation of the setup. Strong RF currents induced by the transmitter on the cabling can distort the transmitter's field, alter its matching, can overheat or overstress the components and even induce potentially dangerous RF power depositions in the subject's tissue. To prevent such interactions, cable currents are blocked by deploying RF baluns [1, 2], traps [3] or ground breakers [4]. These devices are however relatively bulky and costly devices. Furthermore, they can, being resonant circuits, couple to the transmit RF field and can potentially produce large amounts of heat. In order to prevent mentioned coupling these devices can be shielded, which in turn can lead to distortions of the low-frequency switching gradient fields.

With increasing RF frequency, the mentioned interactions between the different antenna elements and their cabling become more pronounced. Typically, baluns and RF trapping circuits are positioned at distances of the order of a quarter of the wavelength and hence ever closer to each other due to the shorter wavelengths at higher frequencies. For transceiver arrays, the problem of coupling between the transceiver elements and their cabling has been resolved by introducing an additional RF shield through which the RF lines penetrate [5]. The individual cables were thereby equipped with baluns in close vicinity to the points, where the cables penetrate the shield.

In typical setups using dedicated transmitter or transmitter arrays in combination with receivers or receiver arrays this solution has not been pursued in the same way since normally the receiver has to move out of the transmitter for loading the patient into the MRI scanner. Furthermore, on most clinical systems the transmitters (body coils) are mounted firmly in the bore, and can hence not move with the receiver coil. Furthermore, on those systems, the RF shielding is mounted to the gradient coil. It is hence not possible to protrude it and to mount electronics outside the RF shield.

### Summary of the Invention

It is thus an object of the present invention to provide an improved coil assembly for MR imaging applications. In particular, such an assembly shall overcome the limitations and disadvantages of presently known systems.

According to one aspect of the invention, a coil assembly for MR imaging applications comprises:
- an electrically conducting RF transmitter coil arrangement for generating an excitation field at an MR operating frequency, the transmitter coil arrangement forming a tubular structure disposed around an imaging volume and having a longitudinal axis;
- an external RF shield surrounding the transmitter coil arrangement;
- at least one electrically conducting RF receiver coil disposed within the imaging volume for receiving MR signal from a subject or object disposed therein, the receiver coil being electrically connected, at a connection point thereof, to a respective RF receive line connectable to a receiver device located outside of the external RF shield;
wherein
- the respective RF receive line of said receiver coil is oriented substantially perpendicular to the longitudinal axis in a receiver-proximal segment between the connection point and a neighboring face portion of the external RF shield through which the receive line is conducted.

The term "tubular structure" in the context of the transmitter coil arrangement shall be understood as a hollow structure with a substantially closed peripheral surface and two end regions, which can be open or close, and which are disposed at opposing ends of a longitudinal axis of the hollow structure. For convenience, the expression "transmitter coil arrangement forming a tubular structure" will also be called "tubular transmitter coil".

As generally known from MR imaging, a tubular transmitter coil can be arranged around an imaging volume of the assembly and is used to send a strong RF excitation field at an MR operating frequency towards a subject or object disposed within the imaging volume. An external RF shield surrounding the transmitter coil arrangement serves to protect the surrounding region from exposure to the RF field generated by the transmitter coil arrangement.

The coil assembly further comprises at least one electrically conducting RF receiver disposed within the imaging volume, i.e. within the hollow structure formed by the transmitter coil arrangement. The purpose of the receiver coil(s) is to pick up an MR signal emitted by the subject or object disposed within the imaging volume following excitation by means of the transmitter coil arrangement. Each receiver coil is electrically connected, at a connection point thereof, to a respective RF receive line which leads to a receiver device. The latter is located outside of the external RF shield in order to be protected from exposure to the strong RF field emitted by the RF transmitter coil arrangement.

In known assemblies, the RF receive lines of any receiver coils located within a tubular transmitter coil are disposed substantially along the longitudinal axis thereof and emerge from the tubular transmitter coil and from the external RF shield surrounding the latter in one of the two end regions. Such a longitudinal arrangement of the RF receive lines appears convenient in view of the need to position each receiver coil at an appropriate location after the subject or object has been brought into the imaging volume.

However, it was found that orienting the respective RF receive line of each receiver coil substantially perpendicular to the longitudinal axis in a receiver-proximal segment between the connection point and a neighboring face portion of the external RF shield provides unexpected advantages. With such configuration, each receive line is conducted through a respective neighboring face portion of the external RF shield, for which purpose the RF shield is provided with an appropriate passage or feedthrough.

The receive lines are only exposed to the excitation field, i.e. to the electric and magnetic fields produced by the transmitter, inside the shield. Outside the shield no substantial excitation field portions are present. This reduces the naturally occurring coupling between transmitter and receivers. Furthermore, electronics of the receiver that are sensitive or are likely to exhibit unfavorable coupling to the excitation fields, such as the pre-amplifier or the detuning and common mode rejection circuits, can be placed outside of the shield. This allows using a simpler setup and reducing the need for additional shielding of said sensitive components, which additional shielding would inflict additional eddy current induced distortions of the switching gradient fields in the MRI scanner.

Furthermore, the electric fields generated by the transmitter can induce large currents on the receive lines. These cable currents can distort the transmitter's field leading to a reduction in transmitting efficiency, loss in SNR, image contrast degradations or even to localized, potentially dangerous high-power deposition in the subject's tissue. For most transmitter topologies, in the central region of the transmitter, the electric field lines point significantly in z-direction, i.e. in the longitudinal direction in the imaging volume. Therefore, routing the cables over a comparably short distance and orthogonally to the field, i.e. perpendicularly to the longitudinal axis, in accordance with the invention reduces the generation of large cable currents.

The reduced coupling between transmitter and receiver also enhances the stability under different loading and temporal stability of the RF setup leading to more even performance, less signal fluctuations and a high temporal SNR in dynamic studies such as required in functional MRI modalities.

Having shorter cables as receive lines leads generally to a reduction of losses due to dissipation of the receiver signal in the cable. This is of particular relevance when pre-amplifier decoupling is established, for example in large channel count arrays, where standing waves inside the cable can lead to strong dissipation losses.

Placing the preamplifiers, and in some cases the detuning circuit, outside the RF shield offers a significantly enhanced potential for extracting heat generated by operation of these devices. This ability is key for scaling the channel count given the limited heat extraction out from within the imaging volume where metallic heat sinks and ducts cannot be employed.

According to another aspect of the invention, an arrangement for carrying out MR imaging or spectroscopy of a subject or object comprises an MR apparatus operatively connected to a coil assembly according to the first aspect, the MR apparatus comprising:
a) magnet means for generating a main magnetic field along a field direction within the imaging volume of the coil assembly;
b) encoding means for generating encoding magnetic fields superimposed to the main magnetic field;
c) RF transmitter means connected to the assembly's RF transmitter coil arrangement to generate said excitation field at said MR operating frequency;
d) driver means for operating the encoding means and RF transmitter means to generate superimposed time dependent encoding fields and radiofrequency fields according to an MR sequence for forming images or spectra; and
e) acquisition means comprising a receiver device located outside of the assembly's external RF shield, the receiver device being connected to at least one RF receive line for acquiring MR signal;
the longitudinal axis of the coil assembly being substantially parallel to the main magnetic field.

Advantageous embodiments are defined in the dependent claims and described further below.

According to one embodiment (claim 2), the coil assembly further comprises a support structure made of a non-conducting material and arranged within the external RF shield, to which support structure the transmitter coil arrangement is rigidly connected and each receiver coil is rigidly connectable.

According to a further embodiment (claim 3), the tubular structure is substantially cylindrical, i.e. its inner surface is cylindrical apart from certain local structures such as, e.g. rungs, connector ports or other electronic components of a transmitter coil arrangement. In such an embodiment, in the central region of the transmitter, the electric field lines of the RF excitation field are substantially parallel to the longitudinal axis and hence to the main magnetic field B₀.

According to one embodiment (claim 4), the transmitter coil arrangement is of birdcage or TEM resonator type. Alternatively, it is a travelling wave arrangement [6] or a transmitter based on a dielectric resonator principle.

According to another embodiment (claim 5), the transmitter coil arrangement is an array of loops, dipoles or folded dipoles, (micro-)strip lines or TEM lines. Other typical transmitter array topologies can be used in the present invention such as mode degenerate birdcages [7], TEM and dielectric resonators and others as well as multi-channel travelling wave feeding structures [8].

Advantageously (claim 6), the transmitter coil arrangement is provided with at least one RF transmitter line traversing the RF shield at a transmitter passage region to reach an RF transmitter supply device located outside of the external RF shield, with at least one of said RF transmitter lines being oriented substantially perpendicular to the longitudinal axis (A) in a region proximal to said transmitter passage region.

In certain embodiments (claim 7), the coil assembly further comprises at least one magnetic field probe rigidly connected to the transmitter coil arrangement. Particularly convenient for this purpose are magnetic field probes based on a magnetic resonance measurement. Such MR magnetic field probes have been disclosed e.g. in EP 1582886 A1 or EP 2515132 A1.

Advantageously (claim 8), the magnetic field probe is electrically connected, at a connection point thereof, to a respective RF probe line leading to a probe transceiver device (30) located outside of the external RF shield, the respective RF probe line of each magnetic field probe being oriented substantially perpendicular to the longitudinal axis in a field probe-proximal segment between the connection point and a neighboring face portion of the external RF shield.

According to certain embodiments, the RF receive line and/or RF transmitter line and/or RF probe line is configured as a coaxial cable, a twisted pair cable or a twinax cable. For convenience, any one of the RF receive line, RF transmitter line and/ RF probe line will be generically denoted as "RF line" when discussing features which may be applicable to any one of such RF lines.

It shall be understood that the circuits of each device operate relative to a reference potential. In most cases this reference potential is denoted as "ground" or as "AC ground" in case only alternating return currents are carried. Also, the voltage potential of shield surfaces can be considered to be at a reference voltage in DC or AC, at least if a corresponding connection is made. In the case of the RF line being of differential line pair, the reference voltage is the mean voltage of both signal lines. This corresponding reference voltage plane can be purely virtual or carried by a lining shielding, ground or shielding braid.

When connecting different devices with electrically conductive cables, controlling the voltages and currents between said reference voltages is of eminent importance. Such currents typically flow as common-mode waves (currents or voltages) on single-ended and differential lines. Common-mode waves can be induced by insufficient balancing of connected devices themselves or by induction from external fields. As a result, common-mode currents can increase unwanted channel crosstalk, affect transmission efficiency and/or uniformity, limit the effectiveness of shields or increase the noise figure of the connection.

According to another embodiment (claim 9), the RF potential reference, i.e. the ground or AC ground of the receiver device and/or the transmitter device and/or the probe receiver device are each connected to the RF shield by a respective connection line, each of which is a DC galvanic connection or an AC connection. An AC connection can comprise a parallel DC resistance of high ohmic value in order to prevent large DC charge build-ups potentially resulting in non-linear behavior or signal spikes. AC connection can be provided by discrete capacitors or a distributed capacitance. It is understood, that typically a low net impedance is regarded as beneficial for optimal shield performance. In order to prevent large common-mode currents running on the RF lines, baluns and/or RF traps can be deployed along the RF lines. It is understood, that a combination of one or several baluns and RF traps presenting a high impedance for common-mode currents in series with one or several low-impedance connections (AC, DC or RC type) to the surrounding shield offers very advantageous common-mode isolation properties.

According to a further embodiment (claim 10), the external RF shield is a capacitively slotted shield. It is good practice to avoid DC coupling among different signal lines (RF, control signals and bias), in order to avoid ground loops being exposed to induction by switching gradients and RF. In cases where all lines are connected to the shield, ground loops can be avoided by AC (capacitive) coupling of all cables to the shield/reference voltage planes. Alternatively, portions of the shield from which a line protrudes and is DC connected thereto through its ground is only AC-coupled to patches that are connected to other lines so as to prevent undesirable DC ground loops. Accordingly, the slotting of the RF shield is adapted to the geometric configuration of the protruding RF receive lines. Thereby the patches of the shield form a distributed capacitance with other patches of the surrounding shield.

The coil assembly of the present invention is particularly useful if configured for application on a human head, particularly for brain imaging applications, or if it is configured for application on a human torso.

According to certain embodiments (claim 11), the coil assembly is configured in such manner that it comprises a free line of sight for optical stimulation in a region between the RF receiver arrangement and the RF shield.

According to an advantageous embodiment (claim 13) of the arrangement for carrying out MR imaging or spectroscopy of a subject or object, the receiver device is attached to the external RF shield on the outside thereof. Such attachment may be implemented by a whole variety of mechanical anchoring means, which preferably provide a releasable attachment such as snap-on or screwable connections. The mechanical anchoring means may be configured to also provide a grounding connection between the receiver device and the external RF shield.

In some embodiments, the receiver device is a pre-amplifier or a reflective pre-amplifier, which can be of a high or low impedance kind.

Advantageously (claim 14), the arrangement comprises at least one balun or RF trap in the RF receive line and/or RF transmitter line and/or RF probe line in order to suppress common mode currents to avoid SNR degradation in the receiver and power loss of the transmitter by blocking evanescent fields penetrating the shield along the receive lines. It is conceived as a preferred embodiment if the signal line guiding the RF signal from the receiver coil element through the shield is of a differential type. Standard topologies as Thevenin lines, twisted pair lines with or without shield or twinax cables can be deployed.

According to one embodiment (claim 15), the balun or the receiver device is electrically connected via a DC or AC connection to the RF shield at least at one point.

Shielding conductors or guards of said signal lines can be electrically connected to the shield. In preferential embodiments, an RF trap, balun or ground breaker placed between the receiver coil and the shield blocks currents from the receiver coil to the shield in order to reduce the coupling from the transmitter to the receiver structure. Common mode blocking means can be combined directly on the coil and in close vicinity to the point, where the receive line penetrates the shield in order to enhance its efficiency.

In another preferred embodiment the receiver is equipped with an active or passive detuning network located outside the external RF shield. This significantly reduces potentially dangerous coupling of the transmitter to the detuning circuit and facilitates extracting heat produced by the circuit.

If additional electrical signals and/or DC supplies are required inside the coil (e.g. detuning currents, amplifier bias, shim currents etc.) these lines are preferentially routed in the same way as the RF lines of the receivers. DC supplies and low frequency signals can further be equipped with RF chokes and a bypass to the shield at the point penetrating the shield (e.g. by deploying a feedthrough capacitor, L, T or PI filter).

Furthermore, the preamplifier is preferentially located close to the point where the receive line penetrates the RF shield of the transmitter. The short RF line reduces losses, induced noise and coupling to the transmitter as well as to other receiver channels. Furthermore, signal stability is improved since phase and amplitude drifts of the cable, e.g., with temperature, are equally minimized by the short connection distance. This in particular in the case preamplifier decoupling is established by deploying a reflective preamplifier (of high or low impedance kind). For establishing a preamplifier decoupling, a compact RF phase shifter or appropriate RF delay line might be required between the reflective preamplifier and the coil.

The preamplifier input and the coil feed can be of a differential topology in terms of signaling symmetry. The common-mode rejection ability of the amplifier can then be used to block common-mode noise from the acquired coil signal. This can be applied in addition to or instead of a balun or RF trap.

In a further preferred embodiment, the preamplifier is followed in the signal chain by a receiver front-end. This receiver front-end can be an analog mixing stage converting the signal to another frequency more convenient to be guided out of the bore. Alternatively, a full digital-to-analog converter can be implanted for a plurality of the receive channels guiding the signals digitally out of the bore.

The signals, digital or analog, can furthermore be converted to an optical or wireless signal transmitter in order to reduce the required cabling out of the bore.

The receiving elements can be of surface or vertical loop type, figure-8, dipoles or monopoles. They can further comprise capacitive segmentation, active and passive detuning networks as well as a preamplifier directly on coil.

It is understood, that it can be beneficial in terms of reducing coupling effects if all cables running close the RF shield can be electrically connected to this ground reference.

It is furthermore understood, that in order to avoid eddy currents on the extended RF shield induced by switching gradient fields, the shield should be slotted and capacitively coupled and/or made of a single or several thin layers (on the order of the skin depth) of conductive material. A proven embodiment consists of thin (1 µm to 100 µm thick) dielectric material lined by a thin (1 µm to 50 µm thick) metallic conductor sheet. The slots can then be etched or lasered on both sides such that the remaining overlap forms a sufficient capacitance across the slot. It is understood, that a thin substrate with high dielectric permittivity and preferably with low resistive losses is beneficial for this application. Furthermore, the slots can be bridged by capacitors, preferentially ceramic capacitors. It understood that a capacitor with a series resonance close to the frequency of operation of the coil is beneficial. Furthermore, it is understood, that the slots should follow the path of the RF current induced by the transmitting coil in order to induce low losses to RF transmission. However, at the same time the slots shall limit the extent of eddy currents induced by switching gradients and dynamic shim systems.

It is understood that the same considerations regarding SNR efficiency and common mode current prevention applies to the integration of field probes in such a transmitter and receiver setup. It is regarded as beneficial, that the signal lines of the field probes penetrate the RF shield as the receivers' lines. In particular equipping the probes' signal lines with an RF trap and/or an (AC bypass) connection to the shield can significantly improve the RF situation in the coil. Furthermore, it is understood that eddy current induced distortions of the switching gradient and dynamic shimming fields, in particular from eddy currents running on the RF shield of the transmitter need to be avoided to a higher degree than for normal imaging purpose. Therefore, it is regarded as beneficial to slot the shields conductors finer or to entirely omit it in the vicinity of the probe. Furthermore, the shielding material can be replaced by other materials offering a lower and/or unidirectional DC conductance such as carbon fibers. Furthermore, the RF circuit of the field probes and/or their RF lines can be at least partially of differential topology. Such an embodiment would allow using dedicated baluns, T/R switches, pre-amplifiers and power amplifiers for achieving high common-mode rejection, low losses via cable shield currents, low noise via common-mode currents, suppression of coupling between channels via common-mode suppression and yet maintaining a high shielding efficiency.

According to still further embodiments, the coil assembly comprises means for visual stimulation. In one implementation, a line of sight for presenting visual stimuli to the subject and/or to monitor the subject e.g. by an eye tracker can be provided by different ways. A traditional setup using a mirror or a prism outside the transmitter can be employed to direct the line of sight of the subject to the patient or the service end of the scanner. For this, holes in the shielding or transparent RF shielding made from thin wired meshed or metal layers can be employed. Alternatively, the mirror or prisms can be located inside the coil and projecting to the service end. In a preferred embodiment however, the coil provides a line of sight through the coil setup guided essentially in between the RF shield and the inner shell of the receiver coil. The housing can be made transparent at the portion lining the forehead and its counterpart at the back of the coil setup. Furthermore, optical components can be deployed in the coil housing for tailoring the angle-of-view presented to the subject and to guide the optical path around the electronic components and the housing parts in the coil. Furthermore, a matt screen can be positioned behind the coil or as preferred mounted on the coil housing to enable the visual stimulus to be projected from the service end. This way the stimulus can be presented to the subject with a large viewing angle despite the comparable long bore of ultra-high field systems. The matt screen itself can furthermore be equipped with provisions such as a hole, a lens system or additional mirrors to enable operation of an external eye tracker located at the service end of the magnet concurrently to visual projection.

It is also understood, that such a matt screen or the deflecting mirror/prism can be replaced by electronic screens. It is understood further on, that eye tracking or other optical recording devices (such as for motion capturing) can be located on the back of the coil or in said space between the inner shell of the receiver and the RF shield of the transmitter.

In certain embodiments, the coil assembly further contains means for local adaptive B₀ shimming, which preferably are disposed within the external RF shield. Preferably, the current leads for respective shim coils are routed like the RF lines of the present invention. Advantageously, the shim coil leads contain RF baluns and/or RF traps and are electrically (DC or AC) connected to the shield. It is also contemplated that the means for local adaptive B₀ shimming are part of the external RF shield.

According to further embodiments, the coil assembly additionally contains means for tracking motion of the subject or object disposed within the imaging volume. These can be an inductive motion tracking system or an optical motion tracking system.

According to another embodiment, the means for motion tracking are a field probe based motion tracking system.

### Brief description of the drawings

The above mentioned and other features and objects of this invention and the manner of achieving them will become more apparent and this invention itself will be better understood by reference to the following description of embodiments of this invention taken in conjunction with the accompanying drawings, wherein are shown:
- Fig. 1: an arrangement for carrying out MR imaging of a subject or object according to prior art, as a schematic vertical section;
- Fig. 2: an arrangement for carrying out MR imaging of a subject or object according to the present invention, as a schematic vertical section;
- Fig. 3: a coil assembly according to the present invention, as a schematic perspective representation partially cut away;
- Fig. 4: a coil assembly according to the present invention, as a cross-sectional axial view, and
- Fig. 5: the coil assembly of Fig. 4, as a schematical perspective view.

### Detailed description of the invention

In general, the same reference signs will be used for functionally identical or similar features in the various drawings and will thus not be described multiple times unless necessary for understanding the invention.

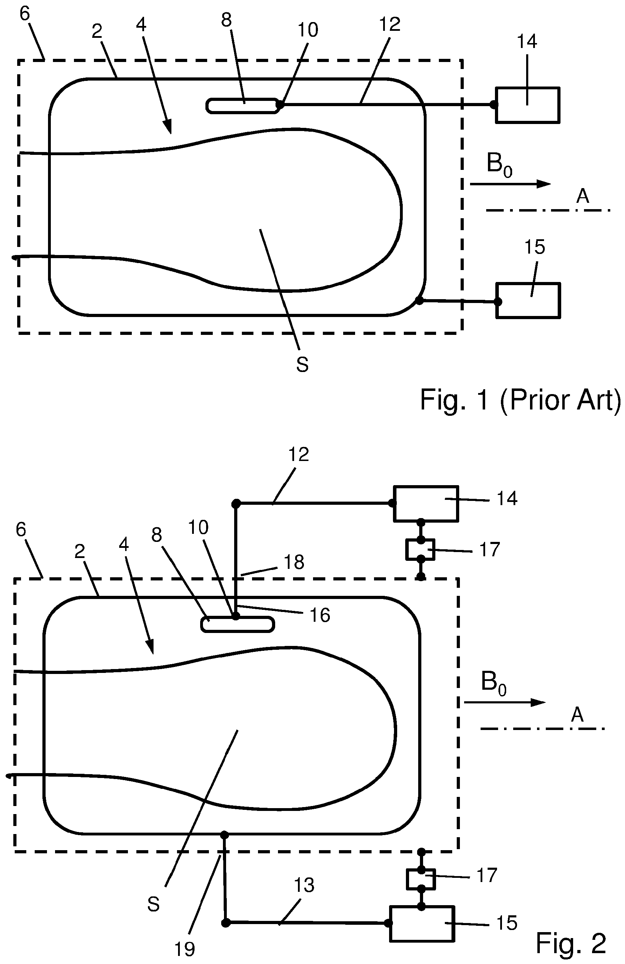

An arrangement for carrying out MR imaging of a subject or object S generally comprises an MR apparatus operatively connected to a coil assembly. Such an arrangement according to prior art is partially shown in Fig. 1. The coil assembly comprises an electrically conducting RF transmitter coil arrangement 2 for generating an excitation field at an MR operating frequency. The transmitter coil arrangement forms a tubular structure disposed around an imaging volume 4 and having a longitudinal axis A. An external RF shield 6, which in the example shown is also substantially tubular, surrounds the transmitter coil arrangement. The coil assembly further comprises an electrically conducting RF receiver coil 8 disposed within the imaging volume for receiving MR signal from the subject or object S disposed therein. The receiver coil 8 has a connection point 10 at which it is electrically connected to a respective RF receive line 12 connectable to a receiver device 14 located outside of the external RF shield 6.

The MR apparatus, which is not shown in detail, comprises: magnet means for generating a main magnetic field B₀ along a field direction within the imaging volume 4; encoding means for generating encoding magnetic fields superimposed to the main magnetic field; RF transmitter means 15 connected to the assembly's RF transmitter coil arrangement 2 to generate said excitation field at said MR operating frequency; driver means for operating the encoding means and RF transmitter means to generate superimposed time dependent encoding fields and radiofrequency fields according to an MR sequence for forming images or spectra; and acquisition means comprising said receiver device 14 located outside of the assembly's external RF shield 6. Under operating conditions, the receiver device 14 is connected to at least one RF receive line 12 for acquiring MR signal. As shown in Fig. 1, the longitudinal axis A of the coil assembly is substantially parallel to the main magnetic field B₀. Moreover, the RF receive line 12 is oriented substantially along the longitudinal axis A of the tubular transmitter coil arrangement and, correspondingly, substantially along the main magnetic field B₀.

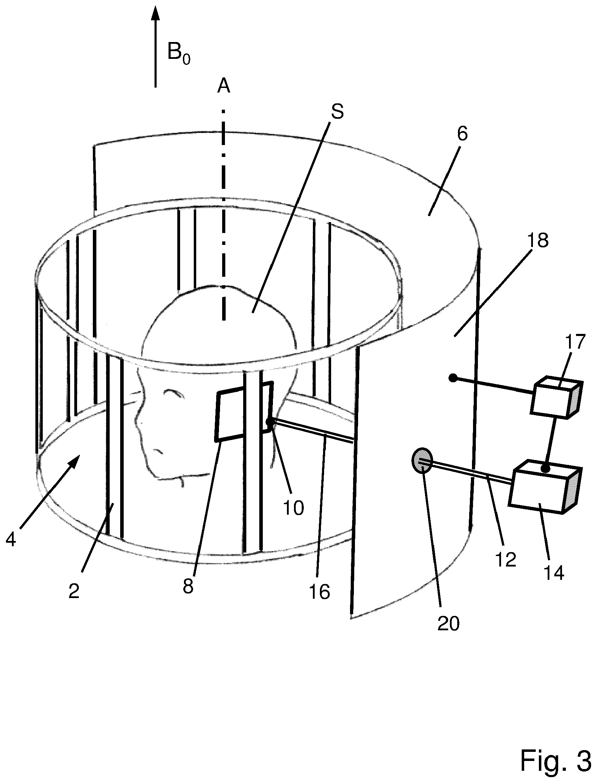

An arrangement configured according to the present invention is shown in Figs. 2 and 3. In contrast to the arrangement of Fig. 1, the respective RF receive line 12 of the receiver coil 8 is oriented substantially perpendicular to the longitudinal axis in a receiver-proximal segment 16 between the connection point 10 and a neighboring face portion 18 of the external RF shield 6 through which the receive line 12 is conducted. As particularly seen from Fig. 2, the transmitter coil arrangement 2 is configured as a substantially cylindrical cage of a type widely used in MRI. The external RF shield 6 surrounding the transmitter coil arrangement is also substantially cylindrical and is arranged substantially co-axially to the transmitter coil. A RF receive line 12 connected to a receiver coil 8 at a connection point 10 thereof has a receiver-proximal segment 16 directed in a substantially radial direction, i.e. substantially perpendicular to the longitudinal axis A and transverses the RF shield 6 at a face portion 18 thereof through a small opening 20. Analogously, the transmitter coil arrangement 2 is provided with at least one RF transmitter line 13 traversing the RF shield at a transmitter passage region 19 to reach an RF transmitter supply device 15 located outside of the external RF shield, the RF transmitter line being oriented substantially perpendicular to the longitudinal axis (A) in a region proximal to the transmitter passage region 19.

Moreover, the ground of the receiver device 14 and/or the ground of the transmitter device 15 and/or the ground of the probe receiver device 30 are each connected to the RF shield 6 by a respective connection line 17, each of which can be a simple DC galvanic connection or an appropriate AC connection comprising, for example, a single capacitor or an RC element. For simplicity of drawing, the ground of each device is shown as a dot located at the periphery / housing of the respective device.

In order to be mechanically stable, a support structure 22 made of a non-conducting material is arranged within the external RF shield 6. The transmitter coil arrangement and the receiver coil 10 are rigidly connected to the support structure 22.

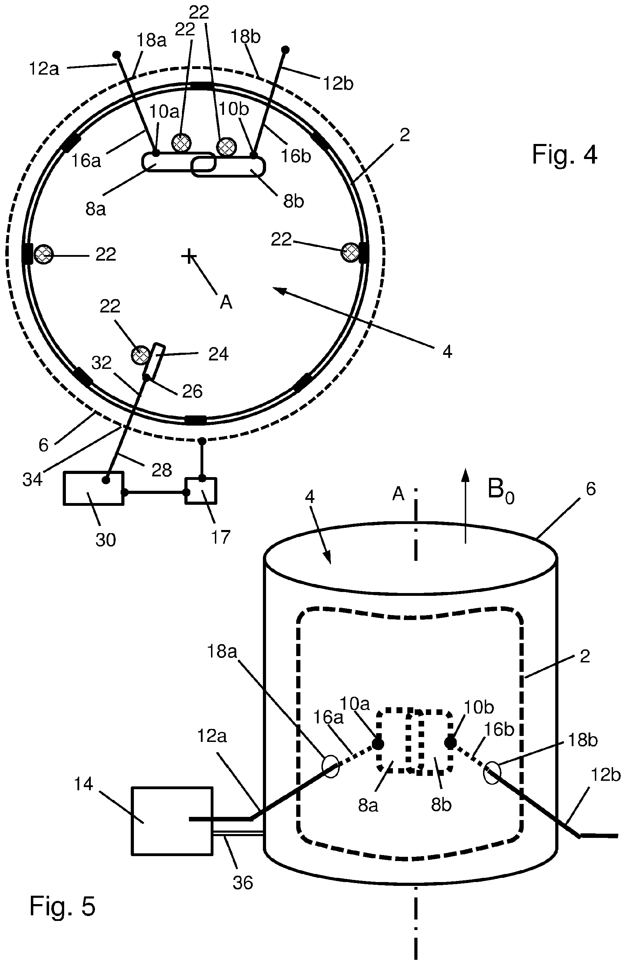

A coil assembly of a further arrangement according to the present invention is shown in Figs. 4 and 5. In contrast to the embodiment of Figs. 2 and 3, the coil assembly comprises two receive coils 8a and 8b, which in the example shown are disposed in a mutually overlapping manner.

As schematically shown in Fig. 4, the coil assembly according to an advantageous embodiment further comprises at least one magnetic field probe 24 rigidly connected thereto. The magnetic field probe is electrically connected, at a connection point 26 thereof, to a respective RF probe line 28 leading to a probe receiver device 30 located outside of the external RF shield. The respective RF probe line of each magnetic field probe is oriented substantially perpendicular to the longitudinal axis (A) in a field probe-proximal segment 32 between the connection point 26 and a neighboring face portion 34 of the external RF shield. In the example of Fig. 5 the receiver device 14 is mechanically attached to the external RF shield 6 by a mechanical anchoring element 36.

### References

1. Eiland, P.F.J., FLEXIBLE BAZOOKA BALUN, P. State College, assignor, by mesne assignments, to HRB-Singer', Inc., State College, Pa., a corporation of Delaware, Editor. 1960: US.
2. Frankel, S., Reactance Networks for Coupling between Unbalanced and Balanced Circuits. Proceedings of the IRE, 1941. 29(9): p. 486-493.
3. Seeber, D., A. Menon, and J. Jevtic, Floating radio frequency trap for shield currents. 2002, Invivo Corp: US.
4. Arakawa, M., T. Minemura, and S. Krasnor, GROUND BREAKER FOR MULTIPLE CONTROL LINES. 1996, The Regents of the University of California, Berkeley, Calif.: US.
5. Brunner, D.O., et al. A symmetrically fed microstrip coil array for 7T. in Proc Intl Soc Magn Reson Med. 2007. Berlin.
6. Brunner, D.O., et al., Travelling-wave nuclear magnetic resonance. Nature, 2009. 457(7232): p. 994-998.
7. Alagappan, V., et al., Degenerate mode band-pass birdcage coil for accelerated parallel excitation. Magnetic Resonance in Medicine, 2007. 57(6): p. 1148-1158.
8. Brunner, D.O., et al., Traveling-wave RF shimming and parallel MRI. Magnetic Resonance in Medicine, 2011. 66(1): p. 290-300.

## Claims

1. A coil assembly for MR imaging applications, comprising
- an electrically conducting RF transmitter coil arrangement (2) for generating an excitation field at an MR operating frequency, the transmitter coil arrangement forming a tubular structure disposed around an imaging volume (4) and having a longitudinal axis (A);
- an external RF shield (6) surrounding the transmitter coil arrangement;
- at least one electrically conducting RF receiver coil (8; 8a, 8b) disposed within the imaging volume for receiving MR signal from a subject or object disposed therein, the receiver coil being electrically connected, at a connection point (10; 10a, 10b) thereof, to a respective RF receive line (12; 12a, 12b) connectable to a receiver device (14) located outside of the external RF shield;
**characterized in that**
- the respective RF receive line of said receiver coil is oriented substantially perpendicular to the longitudinal axis (A) in a receiver-proximal segment (16; 16a, 16b) between the connection point (10; 10a, 10b) and a neighboring face portion (18; 18a, 18b) of the external RF shield through which the receive line (12; 12a, 12b) is conducted.

2. The coil assembly according to claim 1, further comprising a support structure (22) made of a non-conducting material and arranged within the external RF shield, to which support structure the transmitter coil arrangement is rigidly connected and each receiver coil is rigidly connectable.

3. The coil assembly according to claim 1 or 2, wherein the tubular structure is substantially cylindrical.

4. The coil assembly according to claim 1, wherein the transmitter coil arrangement (2) is of birdcage or TEM resonator type.

5. The coil assembly according to claim 1, wherein the transmitter coil arrangement is an array of loops, dipoles, strip lines or TEM lines.

6. The coil assembly according to one of claims 1 to 5, wherein the transmitter coil arrangement (2) is provided with at least one RF transmitter line(13) traversing the RF shield at a transmitter passage region (19) to reach an RF transmitter supply device (15) located outside of the external RF shield, at least one of said RF transmitter lines being oriented substantially perpendicular to the longitudinal axis (A) in a region proximal to said transmitter passage region (19).

7. The coil assembly according to one of claims 1 to 6, further comprising at least one magnetic field probe (24) rigidly connected to the transmitter coil arrangement (2).

8. The coil assembly according to claim 7, wherein the magnetic field probe is electrically connected, at a connection point (26) thereof, to a respective RF probe line (28) leading to a probe receiver device (30) located outside of the external RF shield (6), the respective RF probe line of each magnetic field probe being oriented substantially perpendicular to the longitudinal axis (A) in a field probe-proximal segment (32) between the connection point (26) and a neighboring face portion (34) of the external RF shield.

9. The coil assembly according to one of claims 1 to 9, wherein the ground of the receiver device (14) and/or the ground of the transmitter device (15) and/or the ground of the probe receiver device (30) are each connected to the RF shield (6) by a respective connection (17), each of which is a DC galvanic connection or an AC connection.

10. The coil assembly according to one of claims 1 to 9, wherein the external RF shield is a capacitively slotted shield.

11. The coil assembly according to one of claims 1 to 10, comprising a free line of sight for optical stimulation in a region between the RF receiver arrangement and the RF shield.

12. An arrangement for carrying out MR imaging or spectroscopy of a subject or object, the arrangement comprising an MR apparatus operatively connected to a coil assembly according to one of the preceding claims,
the MR apparatus comprising:
a) magnet means for generating a main magnetic field (B₀) along a field direction within the imaging volume (4) of the coil assembly;
b) encoding means for generating encoding magnetic fields superimposed to the main magnetic field;
c) RF transmitter means (15) connected to the assembly's RF transmitter coil arrangement (2) to generate said excitation field at said MR operating frequency;
d) driver means for operating the encoding means and RF transmitter means to generate superimposed time dependent encoding fields and radiofrequency fields according to an MR sequence for forming images or spectra; and
e) acquisition means comprising a receiver device (14) located outside of the assembly's external RF shield, the receiver device being connected to at least one RF receive line (12) for acquiring MR signal;
the longitudinal axis (A) being substantially parallel to the main magnetic field (B).

13. The arrangement according to claim 12, wherein the receiver device (14) is attached to the external RF shield (6) on the outside thereof.

14. The arrangement according to one of claims 13 to 15, comprising at least one balun or RF trap in the RF receive line and/or RF transmitter line and/or RF probe line.

15. The arrangement according to one of claims 12 to 14, wherein the balun or the receiver device is electrically connected via a DC or AC connection to the RF shield at least at one point.
